# EUROPEAN PATENT APPLICATION

(11) **EP 4 819 166 A1**
(43) Date of publication of application: **07.10.2026**
(21) Application number: 25874030.7
(22) Date of filing: 23.09.2025
(51) Int. Cl.: G21H 1/06, H10F 30/29

(54) **RADIOACTIVE BATTERY AND POWER DEVICE**

(30) Priority: 24.09.2024 KR 20240129031
(71) Applicant: LG Energy Solution, Ltd., Seoul 07335 (KR)
(72) Inventor: KIM, Dong Myung, Seoul 07335 (KR); KIM, Je Young, Daejeon 34122 (KR); SHIN, Dong Myung, Seoul 07335 (KR)
(74) Representative: BCKIP Part mbB
(86) International application number: PCT/KR2025/014902
(87) International publication number: WO 2026/071676

(57) **Abstract**

The present application may provide a radioactive battery comprising a plurality of radioactive battery cells stacked in a stacking direction, which is one direction, each of the plurality of radioactive battery cells including an electrode layer including a first electrode, a second electrode, and an electrode insulating layer disposed between the first electrode and the second electrode, a radiation source, and an energy conversion layer surrounding at least a portion of the radiation source and disposed between the electrode layer and the radiation source; and connectors disposed in at least some of gaps present between any adjacent radioactive battery cells among the plurality of radioactive battery cells to electrically connect the respective electrode layers of the adjacent radioactive battery cells to each other.

## Description

### Field of the Invention

### CROSS-REFERENCE TO RELATED APPLICATIONS

This application claims the benefit of Korean Patent Application No. 10-2024-0129031 filed on September 24, 2024, and Korean Patent Application No. 10-2025-0137227 filed on September 23, 2025, in the Korean Intellectual Property Office, the disclosures of which are incorporated herein by reference in their entireties.

### Field of the Invention

Example embodiments relate to a radioactive cell and an electric power device including the radioactive cell.

### BACKGROUND

A radio isotope is an element that decays into a stable isotope while emitting radiation. Alpha decay, beta decay, and gamma decay have been known as the ways in which a radio isotope decays. A radio isotope emits alpha rays, beta rays, or gamma rays while it decays, depending on the type. Meanwhile, the time it takes for the amount of radioactivity to decrease to half of its initial amount as a radio isotope decays is called a half-life period. The type of radiation emitted by decay and the half-life period are determined, depending on the types of radio isotopes.

A radioactive cell (or a radioactive battery) is a battery that converts the nuclear fission energy of radio isotopes into electrical energy for use as an electrical power source.

For example, a betavoltaic cell is a battery that uses beta rays that are radiation emitted from a radio isotope, and beta rays are absorbed by a P-N junction semiconductor, thereby forming electron-hole pairs in the depletion region and enabling use as an electric power source through the generated electrons and holes.

### Summary of the Invention

### Technical Problem

An aspect provides a radioactive cell and a power device that may be applied to electronic products, which require high power, by generating high-density power.

### Technical Solution

According to an aspect, a radioactive cell includes: a plurality of radioactive unit cells that includes an electrode layer including a first electrode, a second electrode, and an electrode insulation layer provided between the first electrode and the second electrode, a radioactive source, and an energy conversion layer surrounding at least a portion of the radioactive source and provided between the electrode layer and the radioactive source, and is stacked in a stacking direction that is one direction; and a connector that is provided in at least a gap among gaps that exist between any adjacent radioactive unit cells among the plurality of radioactive unit cells and electrically connects each electrode layer of the adjacent radioactive unit cells.

In a radioactive cell according to an example embodiment, the electrode layer may surround at least a portion of the energy conversion layer.

In a radioactive cell according to an example embodiment, the energy conversion layer may include a type-I semiconductor and a type-II semiconductor, and the first electrode may surround at least a portion of the type-I semiconductor, and the second electrode may surround at least a portion of the type-II semiconductor.

In a radioactive cell according to an example embodiment, the electrode insulation layer may surround at least a portion of a boundary between the type-I semiconductor and the type-II semiconductor.

In a radioactive cell according to an example embodiment, the type-I semiconductor may surround at least a portion of the radioactive source, and the type-II semiconductor may surround a portion of the type-I semiconductor.

In a radioactive cell according to an example embodiment, the energy conversion layer may include a first energy conversion layer and a second energy conversion layer each including a type-I semiconductor and a type-II semiconductor, the first energy conversion layer may surround at least a portion of the radioactive source, and the second energy conversion layer may surround at least a portion of the first energy conversion layer.

In a radioactive cell according to an example embodiment, the type-I semiconductor of the second energy conversion layer may surround at least a portion of the type-II semiconductor of the first energy conversion layer, and the type-II semiconductor of the second energy conversion layer may surround at least a portion of the type-I semiconductor of the first energy conversion layer.

In a radioactive cell according to an example embodiment, at least some of the plurality of radioactive unit cells may further include a dielectric layer that surrounds at least a portion of the radioactive source.

In a radioactive cell according to an example embodiment, the connector may include a plurality of connectors, and some of the connectors may electrically connect the first electrode of one of the adjacent radioactive unit cells and the second electrode of the other one, and the others of the connectors may electrically connect the second electrode of one of the adjacent radioactive unit cells and the first electrode of the other one.

In a radioactive cell according to an example embodiment, the connector may include a plurality of connectors, and some of the connectors may electrically connect the first electrode of one of the adjacent radioactive unit cells and the first electrode of the other one, and the others of the connectors may electrically connect the second electrode of one of the adjacent radioactive unit cells and the second electrode of the other one.

The radioactive cell may further include an insulating layer that is provided in at least a gap among gaps that exist between the adjacent radioactive unit cells, in which the radioactive source may be provided through the insulating layer in the stacking direction.

In a radioactive cell according to an example embodiment, the connector may be provided through the insulating layer in the stacking direction.

In a radioactive cell according to an example embodiment, the insulating layer may further include a dielectric layer surrounding at least a portion of the radioactive source provided in the insulating layer.

In a radioactive cell according to an example embodiment, the insulating layer may further include a semiconductor layer surrounding at least a portion of the radioactive source provided in the insulating layer.

In a radioactive cell according to an example embodiment, the semiconductor layer may be exposed from the insulating layer and may be in contact with the energy conversion layer of each of the adjacent radioactive unit cells in the stacking direction.

In a radioactive cell according to an example embodiment, the semiconductor layer may include a type-A semiconductor and a type-B semiconductor, and the type-A semiconductor may surround at least a portion of the radioactive source provided in the insulating layer, and the type-B semiconductor may surround at least a portion of the type-A semiconductor.

In a radioactive cell according to an example embodiment, the semiconductor layer may include a first semiconductor layer and a second semiconductor layer each including a type-A semiconductor and a type-B semiconductor, the first semiconductor layer may surround at least a portion of the radioactive source provided in the insulating layer, the second semiconductor layer may surround at least a portion of the first semiconductor layer.

In a radioactive cell according to an example embodiment, the type-A semiconductor of the second semiconductor layer may surround at least a portion of the type-B semiconductor of the first semiconductor layer, and the type-B semiconductor of the second semiconductor layer may surround at least a portion of the type-A semiconductor of the first semiconductor layer.

In a radioactive cell according to an example embodiment, the energy conversion layer may include a first energy conversion layer and a second energy conversion layer each including a type-I semiconductor and a type-II semiconductor, the first energy conversion layer may surround at least a portion of the radioactive source, and the second energy conversion layer may surround at least a portion of the first energy conversion layer; and the first semiconductor layer may be in contact with the first energy conversion layer in at least a partial region in the stacking direction, and the second semiconductor layer may be in contact with the second energy conversion layer in at least a partial region in the stacking direction.

In a radioactive cell according to an example embodiment, the type-I semiconductor of the second energy conversion layer may surround at least a portion of the type-II semiconductor of the first energy conversion layer, and the type-II semiconductor of the second energy conversion layer may surround at least a portion of the type-I semiconductor of the first energy conversion layer and the type-A semiconductor and the type-B semiconductor of the first semiconductor layer may be in contact with at least a portion of the type-I semiconductor and the type-II semiconductor of the first energy conversion layer, respectively, and the type-A semiconductor and the type-B semiconductor of the second semiconductor layer may be in contact with at least a portion of the type-I semiconductor and the type-II semiconductor of the second energy conversion layer, respectively.

In a radioactive cell according to an example embodiment, the type-A semiconductor of the first semiconductor layer and the type-I semiconductor of the first energy conversion layer may have types different from each other, and the type-B semiconductor of the first semiconductor layer and the type-II semiconductor of the first energy conversion layer may have types different from each other, and the type-A semiconductor of the second semiconductor layer and the type-I semiconductor of the second energy conversion layer may have types different from each other, and the type-B semiconductor of the second semiconductor layer and the type-II semiconductor of the second energy conversion layer may have types different from each other.

According to another aspect, a radioactive cell includes: a plurality of radioactive unit cells that includes an electrode layer including a first electrode, a second electrode, and an electrode insulation layer provided between the first electrode and the second electrode, a radioactive source, and an energy conversion layer surrounding at least a portion of the radioactive source and provided between the electrode layer and the radioactive source, and is stacked in a stacking direction that is one direction; and an insulating layer provided in at least a gap among gaps that exist between any adjacent radioactive unit cells among the plurality of radioactive unit cells, and provided at a position corresponding to the electrode layer of each of the adjacent radioactive unit cells; and a connecting part that includes a first connecting part electrically connecting each of the first electrodes of the adjacent radioactive unit cells and a second connecting part electrically connecting each of the second electrodes of the adjacent radioactive unit cells.

### Effects of the Invention

According to example embodiments, it is possible to provide a radioactive cell and a power device that may be applied to electronic products, which require high power, by generating high-density power.

### BRIEF DESCRIPTION OF THE FIGURES

The drawings provided in the present disclosure are based on example embodiments of the present disclosure, and the ratios of the width, length, or thickness (or height) of components are provided for a detailed description of the present disclosure and may differ from the actual dimensions. Further, in the coordinate system illustrated in the drawings, the axes may be perpendicular to one another, the direction indicted by arrows may be positive direction, and the directions (directions rotated by 180 degrees) opposite to the direction indicted by arrows may be negative directions.
FIG. 1 is a perspective view illustrating at least a portion of a radioactive cell according to an example embodiment of the present disclosure.
FIG. 2 is a plan view illustrating at least a portion of a radioactive unit cell of the radioactive cell according to an example embodiment of the present disclosure.
FIG. 3 is a perspective view illustrating at least a portion of a radioactive unit cell of the radioactive cell according to an example embodiment of the present disclosure.
FIG. 4 is a plan view illustrating at least a portion of a radioactive unit cell of the radioactive cell according to an example embodiment of the present disclosure.
FIG. 5 is a plan view illustrating at least a portion of a radioactive unit cell of the radioactive cell according to an example embodiment of the present disclosure.
FIG. 6 is a perspective view illustrating at least a portion of a radioactive cell according to an example embodiment of the present disclosure.
FIG. 7 is a plan view illustrating at least a portion of an insulating layer of a radioactive cell according to an example embodiment of the present disclosure.
FIG. 8 is a plan view illustrating at least a portion of an insulating layer of a radioactive cell according to an example embodiment of the present disclosure.
FIG. 9 is a perspective view illustrating at least a portion of a radioactive cell according to an example embodiment of the present disclosure.
FIG. 10 is a plan view illustrating at least a portion of an insulating layer of a radioactive cell according to an example embodiment of the present disclosure.
FIG. 11 is a plan view illustrating at least a portion of an insulating layer of a radioactive cell according to an example embodiment of the present disclosure.
FIG. 12 is a perspective view illustrating at least a portion of a radioactive cell according to an example embodiment of the present disclosure.
FIG. 13 is a perspective view illustrating at least a portion of a radioactive cell according to an example embodiment of the present disclosure.

### DETAILED DESCRIPTION

Before describing the present disclosure, the terms or terminologies used herein and claims may not be construed as common meanings or the meanings in dictionaries. Further, the inventor(s) may appropriately define the concepts of terms in accordance with the principle that the inventor(s) may describe their disclosures in the best possible way, and the terms should be interpreted in a manner consistent with the technical idea of the present disclosure. The example embodiments described in this specification and the structures illustrated in the drawings are merely the most example embodiments of the present disclosure and may not represent the entire technical idea of the present disclosure. Accordingly, as of the filing date of the present disclosure, various equivalents and modifications that may replace these may exist.

The reference numerals or symbols described in the accompanying drawings of the specification may indicate parts or components that perform substantially the same functions. For the convenience of description and understanding, the same reference numbers or symbols may be used for description even in different example embodiments. That is, even if components having the same reference numbers are illustrated in multiple drawings, it may not necessarily mean that all of the multiple drawings represent one embodiment.

In the following description, singular forms are intended to include plural forms unless the context clearly indicates otherwise. It will be further understood that the terms **"**comprise**"** or **"**constitute**"** used in this specification specify the presence of stated features, steps, operations, components, parts, or a combination thereof, but do not preclude the presence or addition of one or more other features, numerals, steps, operations, components, parts, or a combination thereof.

In addition, in the following description, terms such as upper side, upper portion, lower side, lower portion, side, front, and rear are based on the directions illustrated in the drawings, and they may be expressed differently when the direction of the subject changes.

Further, terms including ordinal numbers such as **"**first**"** and **"s**econd**"** may be used in the specification and claims to discriminate components. Such ordinal numbers are used to distinguish the same or similar components from each other, the meanings of terms should not be limited by such ordinal numbers. For example, the order of use or the order or arrangement of a component combined with an ordinal number should not be limited by the number. If necessary, ordinal numbers may be exchanged with each other.

Hereinafter, example embodiments of the present disclosure are described in detail with reference to the accompanying drawings. However, the spirit of the present disclosure may not be limited to the proposed example embodiments. For example, those skilled in the art who understand the spirit of the present disclosure may propose other example embodiments that fall within the scope of the present disclosure by adding, modifying, or removing components, and such example embodiments is also be considered to fall within the scope of the present disclosure. The shapes and sizes of the components in the drawings may be exaggerated for more clear explanation.

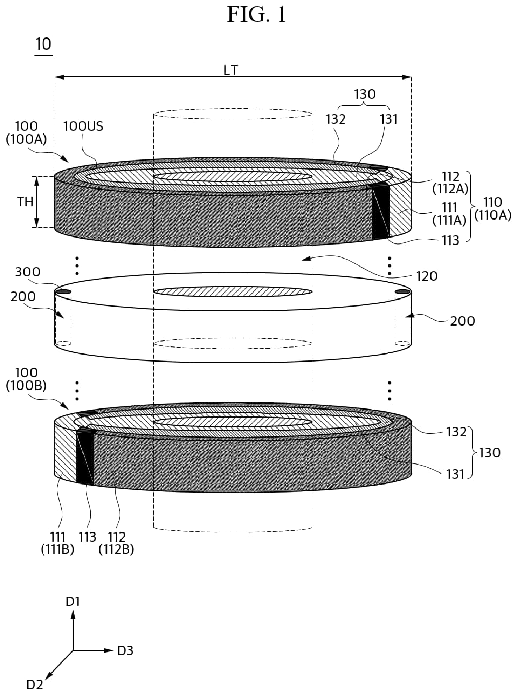

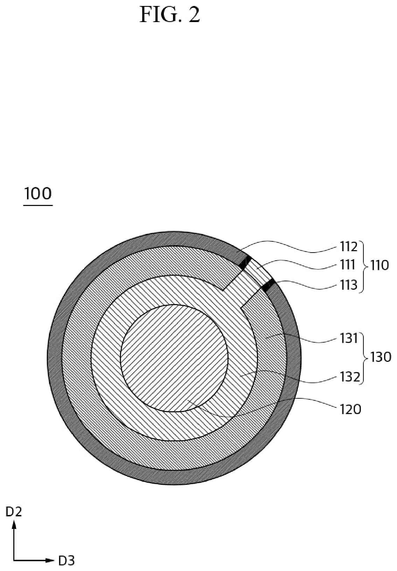

FIG. 1 is a perspective view illustrating at least a portion of a radioactive cell 10 according to an example embodiment of the present disclosure. FIG. 2 is a plan view illustrating at least a portion of a radioactive unit cell 100 of the radioactive cell 10 according to an example embodiment of the present disclosure.

In an example, the radioactive cell 10 may include: a plurality of radioactive unit cells 100 that includes an electrode layer 110, a radioactive source 120, and an energy conversion layer 130; and a connector 200 that is provided in at least a gap among gaps that exist between any adjacent radioactive unit cells 100A and 100B among the plurality of radioactive unit cells 100 and electrically connects the electrode layers 110A and 110B of the adjacent radioactive unit cells 100A and 100B, respectively.

The present disclosure may provide the radioactive cell 10 that may be applied to electronic products, which require high power, by generating high-density energy. Electronic products requiring high power may be all of the power-consuming products, for example, semiconductor memories such as DRAM or NAND flash, processors, mobile devices, vehicles, drones and computers. In this specification, electronic products requiring high power may be referred to as a load.

The radioactive cell 10 according to an example embodiment of the present disclosure may include the radioactive unit cell 100. In an example, the radioactive cell 10 may include the plurality of radioactive unit cells 100 and may electrically connect the radioactive unit cells 100. In an example, the radioactive cell 10 may be advantageous in generation of high-density energy by electrically connecting the plurality of radioactive unit cells 100.

In an example, the radioactive cell 10 may include the plurality of radioactive unit cells 100 stacked in a stacking direction (for example, D1 in FIG. 1) that is one direction. The plurality of radioactive unit cells 100 may be stacked in a direction. When the plurality of radioactive unit cells 100 are stacked, it is advantageous in terms of yield and scale-up.

In an example, an upper surface 100US of the radioactive unit cell may refer to one surface of the radioactive unit cell 100 depending on a stacking direction D1. In this specification, a first crossing direction D2 may refer to a direction that is parallel to the upper surface 100US of the radioactive unit cell and intersects the stacking direction D1, and a second crossing direction D3 may refer to a direction that is parallel to the upper surface 100US of the radioactive unit cell and intersects both the stacking direction D1 and the first crossing direction D2.

The radioactive unit cell 100 according to an example embodiment of the present disclosure may include the electrode layer 110. The electrode layer 110 may include an electrode and the electrode may include an anode that provides electrons and a cathode that receives electrons.

In an example, the electrode layer 110 may include, as electrodes, a first electrode 111 and a second electrode 112. The second electrode 112 may be a counter electrode of the first electrode 111. That is, when the first electrode 111 is an anode, the second electrode 112 may be a cathode, and when the first electrode 111 is a cathode, the second electrode 112 may be an anode. In an example, the first electrode 111 may be a cathode and the second electrode 112 may be an anode.

In an example, the first electrode 111 and the second electrode 112 may be current collectors. The first electrode 111 and the second electrode 112 are not specifically limited in terms of type, size, shape as long as they have electrical conductivity without causing physical or chemical changes with other elements in the radioactive cell 10. For example, the first electrode 111 and the second electrode 112 may have a torus shape. Further, for example, the first electrode 111 and the second electrode 112 may include metallic materials such as gold (Au), silver (Ag), platinum (Pt), stainless steel, copper (Cu), aluminum (Al), nickel (Ni), or titanium (Ti), may include transparent oxides such as fluorine (F)-doped tin oxide (FTO) or indium tin oxide (ITO, In₂₋ₓSnₓO₃, 0<x<2), or may include carbon-based compounds such as carbon-nanotubes, graphene, or graphene oxide.

In an example, the electrode layer 110 may include an electrode insulation layer 113 provided between the first electrode 111 and the second electrode 112. In an example, the electrode layer 110 may have the first electrode 111 and the second electrode 112 provided in one layer, and the electrode insulation layer 113 is provided between the first electrode 111 and the second electrode 112, whereby short circuits may be prevented. In an example, since both of the first electrode 111 and the second electrode 112 are provided in one layer, it is possible to minimize the thickness of the entire electrode layer 110, and accordingly, it is possible to improve power efficiency (power generated per volume) of the radioactive cell 10. In an example, the electrode layer 110 may surround at least a portion of the energy conversion layer 130.

In an example, the electrode insulation layer 113 is not specifically limited as long as it is made of a material with an electrical insulation property, but may include one or more selected from the group consisting of, for example, a silicate (e.g., TEOS), silicon nitride (SiN), hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, and aluminum oxide.

The radioactive unit cell 100 according to an example embodiment of the present disclosure may include the radioactive source 120. In an example, the radioactive source 120 may include a radio isotope. The radio isotope is not specifically limited as long as it decays to emit rays. For example, a radio isotope may include an isotope that emits alpha rays including one or more of americium-241 (²⁴¹Am), americium-243 (²⁴³Am), polonium-209 (²⁰⁹Po), polonium-210 (²¹⁰Po), plutonium-238 (²³⁸Pu), plutonium-239 (²³⁹Pu), curium-242 (²⁴²Cm), curium-244 (²⁴⁴Cm), curium-249 (²⁴⁹Cm), promethium-147 (¹⁴⁷Pm), uranium-238 (²³⁸U), thorium-232 (²³²Th), radium-226 (²²⁶Ra), bismuth-210 (²¹⁰Bi), neptunium-237 (²³⁷Np), europium-152 (¹⁵²Eu), francium-223 (²²³Fr), astatine-210 (²¹⁰At), protactinium-231 (²³¹Pa), einsteinium-253 (²⁵³Es), californium-252 (²⁵²Cf) and berkelium-249 (²⁴⁹Bk). In another example, the radio isotope may include an isotope that emits beta rays including one or more of tritium (³H), calcium-45 (⁴⁵Ca), nickel-63 (⁶³Ni), copper-67 (⁶⁷Cu), strontium-90(⁹⁰Sr), promethium-147(¹⁴⁷Pm), osmium-194 (¹⁹⁴OS), thulium-171 (¹⁷¹Tm), tantalum-179 (¹⁷⁹Ta), cadmium-109 (¹⁰⁹Cd), germanium-68 (⁶⁸Ge), cerium-159 (¹⁵⁹Ce), and tungsten-181 (¹⁸¹W). In another example, the radio isotope may include an isotope that emits gamma rays containing one or more of cobalt-60 (⁶⁰Co), cesium-137 (¹³⁷Cs), iodine-131 (¹³¹I), gallium-67 (⁶⁷Ga) and thallium-201 (²⁰¹Tl). The radio isotopes contained in the radioactive source 120 may include isotopes that emit alpha rays. The radio isotopes contained in the radioactive source 120 may include isotopes that emit beta rays. The radio isotope contained in the radioactive source 120 may include at least one of an isotope that emits alpha rays and an isotope that emits beta rays. The radio isotope contained in the radioactive source 120 may include one or more of an isotope emitting alpha rays, an isotope emitting beta rays, and an isotope emitting gamma rays.

In an example, the radioactive source 120 may be manufactured by one or more of, but not limited to, electroplating (electrolysis plating), electroless plating and chemical vapor deposition (CVD). Among these, the electroplating (electrolysis plating) method may be appropriate when considering radiation shielding and safety of workers.

In an example, the radioactive source 120 may be manufactured into a plating solution for electroplating. For example, when nickel-63 (⁶³Ni) is used as the radioactive source 120, nickel-63 (⁶³Ni) plating solution may be manufactured by irradiating nickel-62 (⁶²Ni) with neutrons to produce nickel-63 (⁶³Ni), which is then chlorinated to produce ⁶³NiCl₂. Alternatively, nickel-62 (⁶²Ni) may be first chlorinated to produce ⁶²NiCl₂, and then irradiated with neutrons to produce a nickel-63 (⁶³Ni) plating solution containing ⁶³NiCl₂.

In an example, the plating solution may further contain additives such as pH adjusters and pH stabilizers, and this may help in uniform formation of the radioactive source 120 by controlling the speed or growth rate of plating.

The radioactive unit cell 100 according to an example embodiment of the present disclosure may include the energy conversion layer 130 surrounding at least a portion of the radioactive source 120 and provided between the electrode layer 110 and the radioactive source 120.

In an example, the energy conversion layer 130 may form electron-hole pairs by the beta rays emitted from the radioactive source 120. In an example, the energy conversion layer 130 may be an inorganic layer, an organic layer, an organic-inorganic hybrid layer, a dye sensitized layer, or a combination thereof, and may generate electrical energy by forming electron-hole pairs using beta rays.

In an example, the inorganic layer may include inorganic materials that generate electrical energy when exposed to light. The inorganic material is not particularly limited, but may include one or more of silicon, single crystal silicon, polycrystalline silicon, amorphous silicon, InGaSe, CuSe, InSe, InGaP, GaAs, chalcopyrite compounds, perovskite compounds, and kesterite compounds.

InGaSe may include one or more of a single or mixture of In, In₄Se₃, InSe, In₂Se₃, GaSe, Ga₂Se₃, and Se. CuSe may include one or more of a single or mixture of Cu, Cu₂Se, CuSe₂ and Se. InSe may include one or more of a single or mixture of In, In₄Se₃, InSe, In₂Se₃, and Se. The chalcopyrite compound may include, for example, one of CuAlS₂, CuAlSe₂, CuAlTe₂, CuGaS₂, CuGaSe₂, CuGaTe₂, CuInS₂, CuInSe₂, CuInTe₂, AgAlS₂, AgAlSe₂, AgAlTe₂, AgGaS₂, AgGaSe₂, AgGaTe₂, AgInS₂, AgInSe₂ and AgInTe₂. The perovskite compound may include, for example, at least one of SrTiO₃ and CaTiO₃. The kesterite compound may include, for example, a group I₂-II-IV-VI₄ kesterite compound. Specifically, the kesterite compound may include one or more of Cu₂ZnSnS₄, Cu₂ZnSnSe₄, Cu₂ZnGeS₄, Cu₂ZnGeSe₄, Cu₂MnSnS₄, Cu₂MnSnSe₄, Cu₂MnGeS₄, Cu₂MnGeSe₄, Ag₂ZnSnS₄, Ag₂ZnSnSe₄, Ag₂ZnGeS₄, Ag₂ZnGeSe₄, Ag₂MnSnS₄, Ag₂MnSnSe₄, Ag₂MnGeS₄ and Ag₂MnGeSe₄.

The organic layer may include an organic material that generates electrical energy by receiving light. The inorganic material is not particularly limited, but may include one or more of fullerene (C₆₀) compounds, phenanthroline derivatives, for example, 2.9-dimethyl-4,7-diphenyl-1,10-phenanthroline (BCP), phenylpyridine derivatives, for example, 4,6-bis(3,5-di-4-pyridinylphenyl)-2-methylpyrimidine (B4PymPm) or tris(2,4,6-trimethyl-3-(pyridin-3-yl)phenyl)borane (3TPYMB), thiophene derivatives, for example, poly(3-hexylthiophene-2,5-diyl) (P3HT), phthalocyanine derivatives, porphyrin derivatives, triarylamine derivatives, carbazole derivatives and oligothiophene.

The organic-inorganic hybrid layer may include an organic-inorganic hybrid material that receives light and generates electrical energy. The organic-inorganic hybrid material may include, but are not particularly limited to, organic-inorganic perovskite compounds. For example, the organic-inorganic hybrid material may include, for example, a halide-based organic-inorganic perovskite compound. The organic-inorganic hybrid material may include one or more of CH₃NH₃PbI₃, CH₃NH₃PbBr₃, CH₃NH₃PbCl₃, CH₃NH₃SnI₃, CH₃NH₃SnBr₃, CH₃NH₃SnCl₃, CH₃NH₃PbI₍₃₋ₓ₎Clₓ, CH₃NH₃PbI₍₃₋ₓ₎Brₓ, CH₃NH₃PbBr₍₃₋ₓ₎Clₓ, CH₃NH₃Pb_{(1-y)}Sn_{y}I₃, CH₃NH₃Pb_{(1-y)}Sn_{y}Br₃, CH₃NH₃Pb_{(1-y)}Sn_{y}Cl₃, CH₃NH₃Pb_{(1-y)}Sn_{y}I₍₃₋ₓ₎Clₓ, CH₃NH₃Pb_{(1-y)}Sn_{y}I₍₃₋ₓ₎Brₓ and CH₃NH₃Pb_{(1-y)}Sn_{y}Br₍₃₋ₓ₎Clₓ (0≤x≤3, 0≤y≤1). The organic-inorganic hybrid material may include those using CFH₂NH₃, CF₂HNH₃, CF₃NH₃, or NH₂CH=NH₂ instead of CH₃NH₃ in the above compound.

The dye-sensitized layer may contain a dye that generates electrical energy when exposed to light. The dye is not particularly limited, but may include one or more of ruthenium complex compounds, indoline organic dyes, and natural dyes. The ruthenium complex may comprise, for example, at least one of N3 and N719. The indoline organic dyes may include, for example, D149. The natural dyes may be extracted from fruits or vegetables, and may include one or more of anthocyanin, chlorophyll, beta-carotene, curcumin, betalain and rosmarinic acid.

In an example, the energy conversion layer 130 may include a scintillator that absorbs the energy of radiation generated from the radioactive source 120 and converts it into optical energy or electrical energy.

For example, the energy conversion layer 130 may include a scintillator at least internally. In another example, the energy conversion layer 130 may include a thin film layer comprising a scintillator provided on at least one surface.

In an example, the scintillator is not particularly limited, but may include one or more of an inorganic compound and an organic compound. The inorganic compound may include, for example, one or more of NaI(Tl), CsI(Tl), GoS, CsI(Tl), CsI(Na), CsI(pure), CsF, KI(Tl), LiI(Eu), BGO, BaF₂, CaF₂(Eu), ZnS(Ag), CaWO₄, CdWO₄, (Y₃Al₅O₁₂(Ce)), GSO, LSO, GAGG:Ce, ZnO(Ga), LaCl₃(Ce) and LaBr₃(Ce). The organic compound may include, for example, one or more of anthracene, stilbene, naphthalene and polyethylene naphthalate.

In an example, the energy conversion layer 130 may include a type-I semiconductor 131 and a type-II semiconductor 132. One of the type-I semiconductor 131 and the type-II semiconductor 132 may be a P-type semiconductor and the other one may be an N-type semiconductor. That is, the type-I semiconductor 131 and the type-II semiconductor 132 may be types different from each other. For example, when the type-I semiconductor 131 is a P-type semiconductor, the type-II semiconductor 132 may be an N-type semiconductor, and when the type-I semiconductor 131 is an N-type semiconductor, the type-II semiconductor 132 may be a P-type semiconductor. In an example, each of the plurality of radioactive unit cells 100 may independently include the type-I semiconductor 131 and the type-II semiconductor 132, and whether each of the type-I semiconductors 131 is a P-type semiconductor (or each of the type-II semiconductors 132 is an N-type semiconductor), or the type-I semiconductor 131 is an N-type semiconductor (or the type-II semiconductor 132 is a P-type semiconductor) may be changed, depending on design.

In this specification, a P-type semiconductor may be, for example, may be silicon or diamond doped with boron (B), aluminum (Al), gallium (Ga), or indium (In) that are group 13 elements of the periodic table, or may be a compound semiconductor doped with boron (B), aluminum (Al), gallium (Ga), or indium (In) that are group 13 elements of the periodic table. In this specification, a compound semiconductor refers to a semiconductor composed of two or more elements, and, for example, may include silicon carbide (SiC), silicon oxide (SiO₂), aluminum phosphide (AlP), aluminum arsenide (AlAs), gallium arsenide (GaAs), gallium nitride (GaN), or the like. In this specification, a N-type semiconductor may be, for example, may be silicon or diamond doped with nitrogen (N), phosphorus (P), arsenic (As), or antimony (Sb) that are group 15 elements of the periodic table, or may be a compound semiconductor doped with nitrogen (N), phosphorus (P), arsenic (As), or antimony (Sb) that are group 15 elements of the periodic table.

In an example, each of the type-I semiconductor 131 and the type-II semiconductor 132 may independently include a metal oxide having the chemical formula AMO₃. Here, A may be one selected from La, Ba, Sr and K, and M may be one selected from Al, In, Ga, Ti, Sn, Hf, Ta and Zr. In some cases, each of the type-I semiconductor 131 and the type-II semiconductor 132 may independently include multiple different types of metal oxides. Different types could indicate different elements of A or M. In an example, in this case, the type-I semiconductor 131 and the type-II semiconductor 132 may form a homojunction with each other.

For example, each of the type-I semiconductor 131 and the type-II semiconductor 132 may independently include one or more of BaSnO₃, BaHfO₃, BaZrO₃, BaHf₁₋ₓTiₓO₃ (here, 0<x<1), Ba₁₋ₓLaₓSnO₃ (here, 0<x<1), Bi₄Ge₃O₁₂, Al₂O₃, Y₂O₃, La₂O₃, Ga₂O₃, Bi₂O₃, ZrO₂, HfO₂, Ta₂O₅, TiO₂, LaInO₃, LaGaO₃, SrZrO₃, SrHfO₃, SrTaO₇, LaIn₁₋ₓGaₓO₃ (here, 0<x<1), LaGaO₃, SrTiO₃, KTaO₃, HfSiO₄, Ta₃Ti₂Oₓ (here, 0<x<1) and LaAlO₃.

In an example, the electrode layer 110 and the energy conversion layer 130 may be manufactured by, but are not limited to, deposition or epitaxial growth, for example. Here, the deposition may be one or more of physical vapor deposition (PVD), chemical vapor deposition (CVD), and atomic layer deposition (ALD).

In an example, the first electrode 111 may surround at least a portion of the type-I semiconductor 131 and the second electrode 112 may surround at least a portion of the type-II semiconductor 132. In an example, the electrode insulation layer 113 may surround at least a portion of the boundary between the type-I semiconductor 131 and the type-II semiconductor 132. The electrode insulation layer 113 may minimize electrical problems such as a short circuit by surrounding at least a portion of the boundary between the type-I semiconductor 131 and the type-II semiconductor 132 with the first electrode 111 and the second electrode 112 in contact with each other.

In an example, the type-I semiconductor 131 may surround at least a portion of the radioactive source 120. In an example, the type-II semiconductor 132 may surround at least a portion of the type-I semiconductor 131. Such arrangement of the type-I semiconductor 131 and the type-II semiconductor 132 enables improvement of the power efficiency of the radioactive cell 10 by increasing the contact surface area. In an example, it may be advantageous for the power efficiency of the radioactive cell 10 when the beta rays generated from the radioactive source 120 are incident on the widest possible area of the energy conversion layer 130.

In an example, the first electrode 111 may contact at least a portion of the type-I semiconductor 131. Further, the second electrode 112 may contact at least a portion of the type-II semiconductor 132. Further, the radioactive source 120 may contact at least a portion of the type-I semiconductor 131.

In an example embodiment of the present disclosure, the radioactive unit cell 100 may include connectors 200 provided respectively in at least a gap among gaps that exist between any adjacent radioactive unit cells 100A and 100B of the plurality of radioactive unit cells 100 and electrically connecting the adjacent electrodes 110A and 110B of the radioactive unit cells 100A and 100B.

In an example, the connectors 200 may include a conductive material. In this case, the conductive material, for example, may include one or more selected from the group consisting of tin (Sn), indium (In), bismuth (Bi), antimony (Sb), copper (Cu), silver (Ag), zinc (Zn), and lead (Pb). The number, gap, arrangement, and shape of the connectors 200 are not limited to those illustrated in the figured and may be changed, depending on design. In an example, the connectors 200 may have a solder ball or solder bump shape.

In an example, the adjacent radioactive unit cells 100A and 100B may include a first radioactive unit cell 100A and a second radioactive unit cell 100B. The configurations included in each of the radioactive unit cells 100A and 100B may refer to the contents described above or to be described below, as long as they are not contradictory. The first radioactive unit cell 100A may include: an electrode 110A including a 1-1 electrode 111A, a 1-2 electrode 112A, and the electrode insulation layer 113; the radioactive source 120; and the energy conversion layer 130. The second radioactive unit cell 100B may include: an electrode 110B including a 2-1 electrode 111B, a 2-2 electrode 112B, and the electrode insulation layer 113; the radioactive source 120; and the energy conversion layer 130. In an example, the adjacent radioactive unit cells 100A and 100B, as described above, may be electrically connected through the connectors 200.

Referring to FIG. 1, the width LT of the radioactive unit cell 100 may be greater than the thickness TH of the radioactive unit cell 100. Here, the width LT of the radioactive unit cell 100 may indicate the width for the first crossing direction D2 or the second crossing direction D3, and the thickness TH of the radioactive unit cell 100 may indicate the width for the stacking direction D1. This allows for the formation of a more densely stacked structure of the radioactive unit cells 100.

In an example, the ratio (TH/LT) of the thickness TH of the radioactive unit cells 100 to the width LT of the radioactive unit cells 100 may be 0.005 to 0.01, 0.0055 to 0.015 or 0.006 to 0.02. This allows for the formation of a more densely stacked structure of the radioactive unit cells 100. Further, the width LT of the radioactive unit cell 100 may be, for example, 1 cm to 50 cm, 5 cm to 30 cm, or 10 cm to 20 cm. Further, the thickness TH of the radioactive unit cell 100 may be, for example, 10 µm to 300 µm, 50 µm to 250 µm or 100 µm to 200 µm.

Referring to FIG. 2, in an example, when viewed from the stacking direction D1, the energy conversion layer 130 may surround at least a portion of the radiation source 120. Further, when viewed in the stacking direction D1, the energy conversion layer 130 and the radiation source 120 may not overlap each other. In an example, when viewed in the stacking direction D1, the electrode layer 110 may surround at least a portion of the energy conversion layer 130. Further, when viewed in the stacking direction D1, the electrode layer 110 and the energy conversion layer 130 may not overlap each other.

Referring to FIG. 2, in an example, when viewed in the stacking direction D1, the electrode insulation layer 113 may be provided between the first electrode 111 and the second electrode 112. Further, when viewed in the stacking direction D1, the insulation layer 113 may not overlap with the first electrode 111 and the second electrode 112.

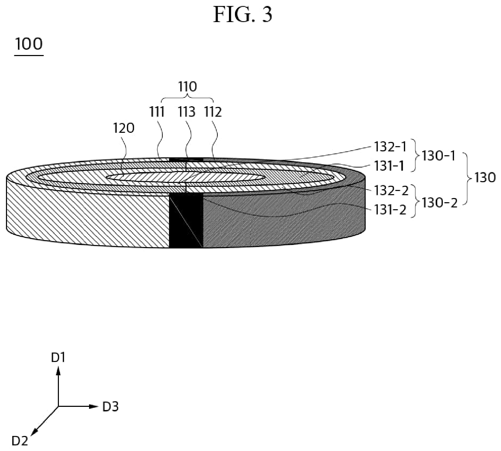

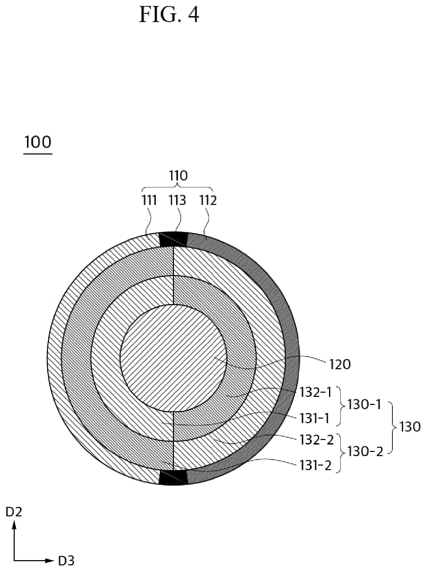

FIG. 3 is a perspective view illustrating at least a portion of the radioactive unit cell 100 of the radioactive cell 10 according to an example embodiment of the present disclosure. FIG. 4 is a plan view illustrating at least a portion of the radioactive unit cell 100 of the radioactive cell 10 according to an example embodiment of the present disclosure.

In an example, the energy conversion layer 130 may include a first energy conversion layer 130-1 and a second energy conversion layer 130-2 that include the type-I semiconductor 131 and the type-II semiconductor 132, respectively. That is, the energy conversion layer 130 may have a multilayer structure and, in this case, the multilayer structure may refer to a structure in which layers do not overlap when seen in the stacking direction D1.

In an example, the first energy conversion layer 130-1 may surround at least a portion of the radioactive source 120 and the second energy conversion layer 130-2 may surround at least a portion of the first energy conversion layer 130-1.

In an example, a type-I semiconductor 131-2 of the second energy conversion layer 130-2 may surround at least a portion of a type-II semiconductor 132-1 of the first energy conversion layer 130-1. In an example, a type-II semiconductor 132-2 of the second energy conversion layer 130-2 may surround at least a portion of a type-I semiconductor 131-1 of the first energy conversion layer 130-1. Such arrangement enables improvement of the power efficiency of the radioactive cell 10 by increasing the contact surface area between the type-I semiconductor 131 and the type-II semiconductor 132.

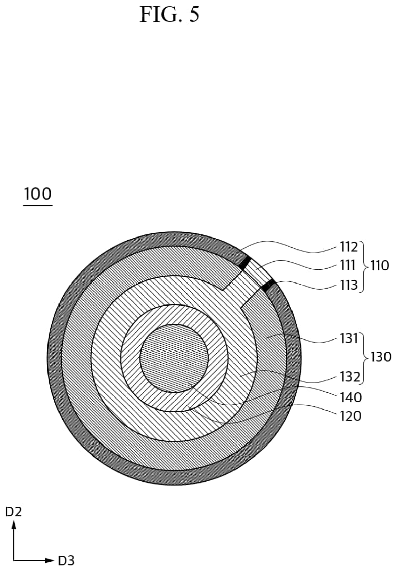

FIG. 5 is a plan view illustrating at least a portion of the radioactive unit cell 100 of the radioactive cell 10 according to an example embodiment of the present disclosure. In an example, at least some of the plurality of radioactive unit cells 100A and 100B may include a dielectric layer 140 surrounding at least a portion of the radioactive source 120.

In an example, the dielectric layer 140 may include a dielectric. In an example, the dielectric is not specifically limited as long as it is used in the field. The dielectric layer 140 may optimize the arrangement of the radioactive source 120 and may further improve electrical stability by minimizing occurrence of leakage current.

In an example, the dielectric layer 140 may include a low-k dielectric with a dielectric constant of less than 3.9. The low-k dielectric is not specifically limited as long as it is used in the field, but may include one or more from the group consisting of Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethyleyCloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), Tonen SilaZen (TOSZ), Fluoride Silicate Glass (FSG), polyimide nanofoams, polypropylene oxide, Carbon Doped silicon Oxide (CDO), Organo Silicate Glass (OSG), SiLK, Amorphous Fluorinated Carbon, silica aerogels, silica xerogels, and mesoporous silica. When the dielectric layer 140 includes a low-k dielectric, it is possible to minimize occurrence of leakage current and, for example, it is possible to enable the beta rays generated from the radioactive source 120 to be efficiently transmitted to the energy conversion layer 130.

In an example, the dielectric layer 140 may include a high-k dielectric with a dielectric constant of 3.9 or higher. The high-k dielectric is not specifically limited as long as it is used in the field, but, for example may include one or more of a group of boron nitride, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, or lead zinc niobate. When the dielectric layer 140 includes a high-k dielectric, it is possible to minimize occurrence of leakage current and design the radioactive unit cell 100 with a high integration density.

It may include one or more selected from the group consisting of a silicate (e.g., TEOS), silicon nitride (SiN), hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, and aluminum oxide.

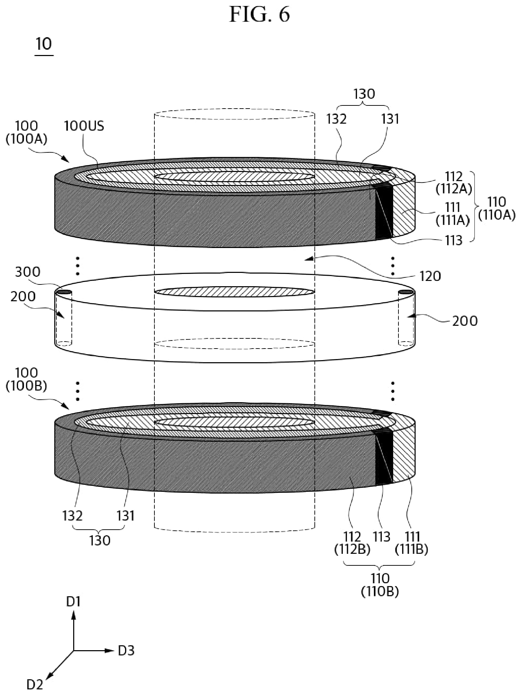

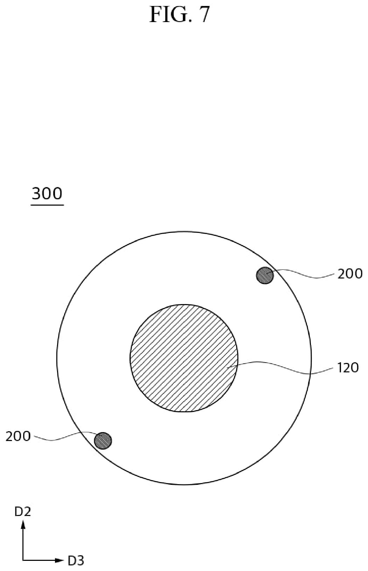

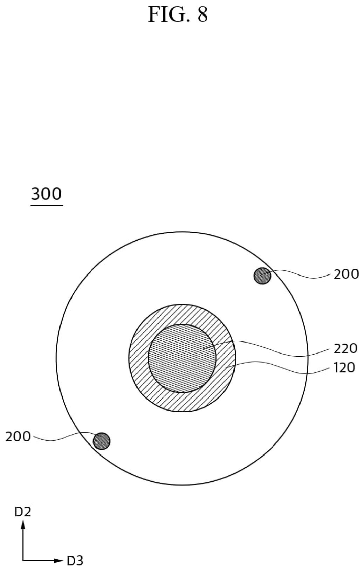

FIG. 6 is a perspective view illustrating at least a portion of the radioactive cell 10 according to an example embodiment of the present disclosure. FIG. 7 is a plan view illustrating at least a portion of an insulating layer 300 of the radioactive cell 10 according to an example embodiment of the present disclosure. FIG. 8 is a plan view illustrating at least a portion of the insulating layer 300 of the radioactive cell 10 according to an example embodiment of the present disclosure.

In an example, a plurality of connectors 200 may be provided. Through arrangement of the connectors 200, the connection way of each of the electrode 110A and 110B of the adjacent radioactive unit cells 100A and 100B may be changed, and in more detail, the adjacent radioactive unit cells 100A and 100B may be electrically connected in series or in parallel through arrangement of the connectors 200.

Referring to FIG. 1, when the adjacent radioactive unit cells 100A and 100B are connected in series, some of the connectors 200 may electrically connect the first electrode 111A of one 100A of the adjacent radioactive unit cells and the second electrode 112B of the other one 100B, and the others of the connectors 200 may electrically connect the second electrode 112A of one 100A of the adjacent radioactive unit cells and the first electrode 111B of the other one 100B. When the adjacent radioactive unit cells 100A and 100B are connected in series, the potential difference of the radioactive cell 10 may be made greater than that of a single radioactive unit cell or a parallel connection of radioactive unit cells, so it is possible to improve the electrical output applied to loads.

Referring to FIG. 6, in an example, when the adjacent radioactive unit cells 100A and 100B are connected in parallel, some of the connectors 200 may electrically connect the first electrode 111A of one 100A of the adjacent radioactive unit cells and the first electrode 111B of the other one 100B, and the others of the connectors 200 may electrically connect the second electrode 112A of one 100A of the adjacent radioactive unit cells and the second electrode 112B of the other one 100B. When the adjacent radioactive unit cells 100A and 100B are connected in parallel, it is possible to improve the lifespan of the radioactive cell 10 in comparison to a single radioactive unit cell or a serial connection of radioactive unit cells.

In an example, the radioactive cell 10 may include the insulating layer 300 provided in at least a gap among gaps that exist between the adjacent radioactive unit cells 100A and 100B. In an example, the insulating layer 300 may be provided between adjacent radioactive unit cells 100 in which the connector 200 is provided. Meanwhile, the insulating layer 300 may prevent a short circuit due to contact between electrodes and may prevent unexpected damage due to transmission of beta rays generated from the radioactive source 120 of each of the radioactive unit cells 100 to other radioactive unit cells 100.

In an example, the insulating layer 300 is not specifically limited as long as it is made of a material with an electrical insulation property, but may include one or more selected from the group consisting of, for example, a silicate (e.g., TEOS), silicon nitride (SiN), hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, and aluminum oxide.

In an example, the radioactive source 120 may be provided through the insulating layer 300 in the stacking direction D1. That is, the radioactive cell 10 may include the radioactive source 120 extending in the stacking direction D1 of the radioactive unit cells 100.

In an example, the connectors 200 may be provided through the insulating layer 300 in the stacking direction D1. That is, the connectors 200 may include an exposed portion exposed from the surface of the insulating layer 300 through the insulating layer 300 and an embedded portion embedded in the insulating layer 300. In an example, the connectors 200 may electrically connect the electrodes 110A and 110B of the adjacent radioactive unit cells 100A and 100B through the exposed portions exposed from both surfaces of the insulating layer 300. Further, in an example, the position of the connectors 200 may be fixed by the embedded portion embedded in the insulating layer 300 and may stably electrically connect the electrodes 110A and 110B of the adjacent radioactive unit cells 100A and 100B.

In an example, the connector 200 may be positioned in at least a portion of a through hole penetrating the insulating layer 300. Here, the through hole in which the connector 200 is placed may be referred to as the aforementioned embedded portion. The through hole may be perforated along the stacking direction D1. The through hole may be manufactured by, but are not limited to, physical penetration methods, wet etching, dry etching, or photo processes. The connector 200 may be placed in at least a portion of the through hole by applying a paste containing a conductive material or by printing.

Referring to FIG. 8, in an example, the insulating layer 300 may include a dielectric layer 220 surrounding at least a portion of the radioactive source 120 provided in the insulating layer 300.

In this case, the dielectric layer 220 provided in the insulating layer 300 may include a dielectric. In an example, the dielectric is not specifically limited as long as it is used in the field. The dielectric layer 220 may optimize the arrangement of the radioactive source 120 and may further improve electrical stability by minimizing occurrence of leakage current.

In an example, the dielectric layer 220 provided in the insulating layer 300 may include a low-k dielectric with a dielectric constant of less than 3.9. The low-k dielectric is not specifically limited as long as it is used in the field, but may include one or more from the group consisting of Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethyleyCloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), Tonen SilaZen (TOSZ), Fluoride Silicate Glass (FSG), polyimide nanofoams, polypropylene oxide, Carbon Doped silicon Oxide (CDO), Organo Silicate Glass (OSG), SiLK, Amorphous Fluorinated Carbon, silica aerogels, silica xerogels, and mesoporous silica. When the dielectric layer 220 provided in the insulating layer 300 includes a low-k dielectric, it is possible to minimize occurrence of leakage current and, for example, it is possible to enable the beta rays generated from the radioactive source 120 to be efficiently transmitted to the energy conversion layer 130.

In an example, the dielectric layer 220 provided in the insulating layer 300 may include a high-k dielectric with a dielectric constant of 3.9 or higher. The high-k dielectric is not specifically limited as long as it is used in the field, but, for example may include one or more of a group of boron nitride, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, or lead zinc niobate. When the dielectric layer 220 provided in the insulating layer 300 includes a high-k dielectric, it is possible to minimize occurrence of leakage current and design the radioactive unit cell 100 with a high integration density.

In an example, as for the dielectric layer 220 provided in the insulating layer 300, at least some of the plurality of radioactive unit cells 100A, 100B described above may be integrally connected with the dielectric layer 140 surrounding at least a portion of the radioactive source 120.

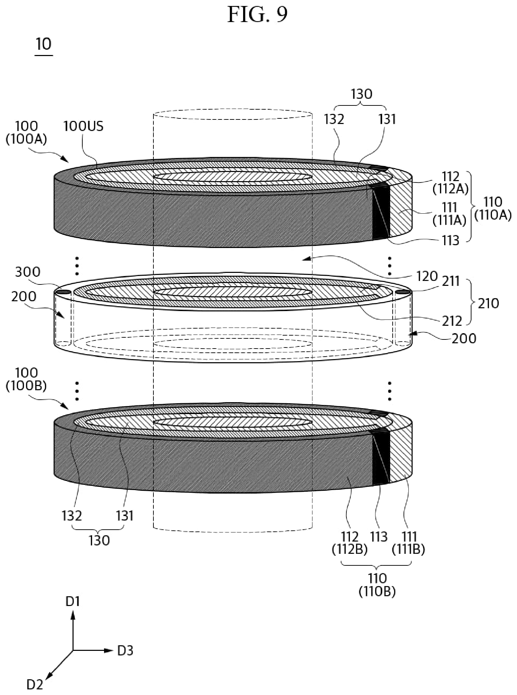

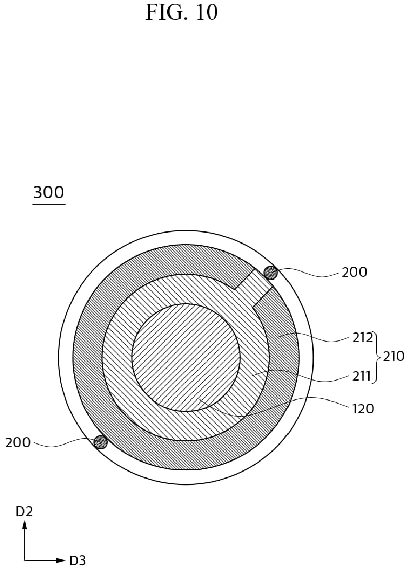

FIG. 9 is a perspective view illustrating at least a portion of the radioactive cell 10 according to an example embodiment of the present disclosure. FIG. 10 is a plan view illustrating at least a portion of the insulating layer 300 of the radioactive cell 10 according to an example embodiment of the present disclosure.

In an example, the insulating layer 300 may include a semiconductor layer 210 surrounding at least a portion of the radioactive source 120 provided in the insulating layer 300. In an example, the semiconductor layer 210 may be exposed from the insulating layer 300 in the stacking direction D1. Further, the semiconductor layer 210 may be in contact with the energy conversion layers 130 of the adjacent radioactive unit cells 100A and 100B. Through this arrangement, the beta rays generated from the radioactive source 120 may be incident on the widest possible area of the energy conversion layer 130, so it is possible to improve the power efficiency of the radioactive cell 10.

In an example, the semiconductor layer 210 may include a type-A semiconductor 211 and a type-B semiconductor 212. One of the type-A semiconductor 211 and the type-B semiconductor 212 may be a P-type semiconductor and the other one may be an N-type semiconductor. That is, the type-A semiconductor 211 and the type-B semiconductor 212 may be types different from each other. For example, when the type-A semiconductor 211 is a P-type semiconductor, the type-B semiconductor 212 may be an N-type semiconductor, and when the type-A semiconductor 211 is an N-type semiconductor, the type-B semiconductor 212 may be a P-type semiconductor.

In an example, the type-A semiconductor 211 may surround at least a portion of the radioactive source 120 provided in the insulating layer 300, and the type-B semiconductor 212 may surround at least a portion of the type-A semiconductor 211. Such arrangement of the type-A semiconductor 211 and the type-B semiconductor 212 enables improvement of power efficiency of the radioactive cell 10 by increasing the contact surface area.

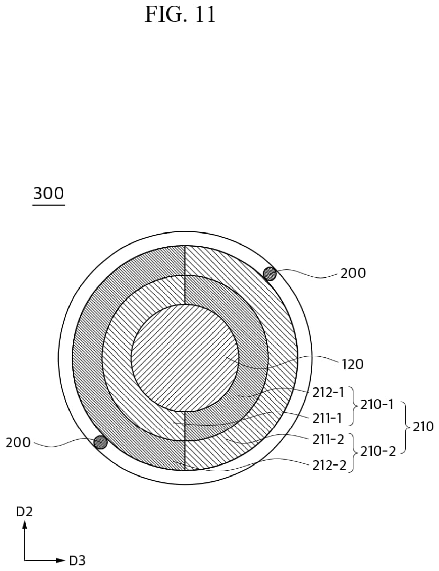

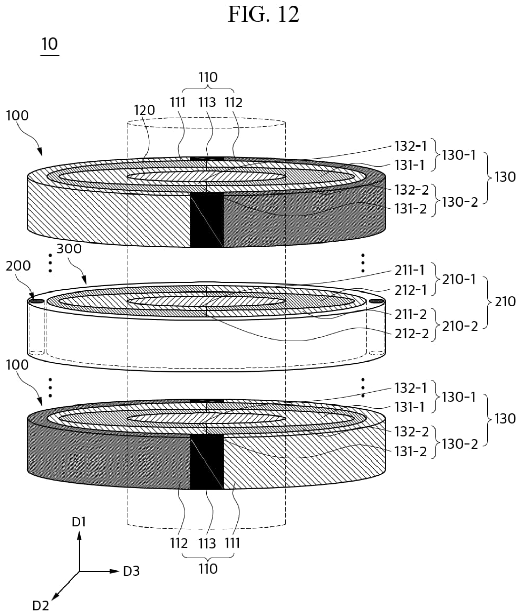

FIG. 11 is a plan view illustrating at least a portion of the insulating layer 300 of the radioactive cell 10 according to an example embodiment of the present disclosure. FIG. 12 is a perspective view illustrating at least a portion of the radioactive cell 10 according to an example embodiment of the present disclosure.

In an example, the semiconductor layer 210 may include a first semiconductor layer 210-1 and a second semiconductor layer 210-2 each including the type-A semiconductor 211 and the type-B semiconductor 212. That is, the semiconductor layer 210 may have a multilayer structure and, in this case, the multilayer structure may refer to a structure in which layers do not overlap when seen in the stacking direction D1.

In an example, the first semiconductor layer 210-1 may surround at least a portion of the radioactive source 120 and the second semiconductor layer 210-2 may surround at least a portion of the first semiconductor layer 210-1.

In an example, the type-A semiconductor 211-2 of the second semiconductor layer 210-2 may surround at least a portion of the type-B semiconductor 212-1 of the first semiconductor layer 210-1. In an example, the type-B semiconductor 212-2 of the second semiconductor layer 210-2 may surround at least a portion of the type-A semiconductor 211-2 of the first semiconductor layer 210-1. Such arrangement enables improvement of the power efficiency of the radioactive cell 10 by increasing the contact surface area between the type-A semiconductor 211 and the type-B semiconductor 212.

In an example, the first semiconductor layer 210-1 may be in contact with at least a partial region of the first energy conversion layer 130-1 in the stacking direction D1. In an example, the second semiconductor layer 210-2 may be in contact with at least a partial region of the second energy conversion layer 130-2 in the stacking direction D1. Such arrangement enables improvement of the power efficiency of the radioactive cell 10 by increasing the contact surface area between the type-A semiconductor 211 and the type-B semiconductor 212.

In an example, the type-A semiconductor 211-1 and the type-B semiconductor 212-1 of the first semiconductor layer 210-1 may be in contact with at least a portion of the type-I semiconductor 131-1 and the type-II semiconductor 132-1 of the first energy conversion layer 310-1, respectively. That is, the type-A semiconductor 211-1 of the first semiconductor layer 210-1 may be in contact with at least a portion of the type-I semiconductor 131-1 of the first energy conversion layer 310-1, and the type-B semiconductor 212-1 of the first semiconductor layer 210-1 may be in contact with at least a portion of the type-II semiconductor 132-1 of the first energy conversion layer 310-1. In an example, the type-A semiconductor 211-2 and the type-B semiconductor 212-2 of the second semiconductor layer 210-2 may be in contact with at least a portion of the type-I semiconductor 131-2 and the type-II semiconductor 132-2 of the second energy conversion layer 130-2, respectively. That is, the type-A semiconductor 211-2 of the second semiconductor layer 210-2 may be in contact with at least a portion of the type-I semiconductor 131-2 of the second energy conversion layer 310-2, and the type-B semiconductor 212-2 of the second semiconductor layer 210-2 may be in contact with at least a portion of the type-II semiconductor 132-2 of the second energy conversion layer 310-2. Such arrangement enables improvement of the power efficiency of the radioactive cell 10 by maximizing the contact surface area between the type-I semiconductor 131, the type-II semiconductor 132, the type-A semiconductor 211, and the type-B semiconductor 212.

In an example, the type-A semiconductor 211-1 of the first semiconductor layer 210-1 may have a different type from the type-I semiconductor 131-1 of the first energy conversion layer 130-1, and the type-B semiconductor 212-1 of the first semiconductor layer 210-1 may have a different type from the type-II semiconductor 132-1 of the first energy conversion layer 130-1. In an example, the type-A semiconductor 211-2 of the second semiconductor layer 210-2 may have a different type from the type-I semiconductor 131-2 of the second energy conversion layer 130-2, and the type-B semiconductor 212-2 of the second semiconductor layer 210-2 may have a different type from the type-II semiconductor 132-2 of the second energy conversion layer 130-2. Such arrangement enables improvement of the power efficiency of the radioactive cell 10 by maximizing the contact surface area between the type-I semiconductor 131, the type-II semiconductor 132, the type-A semiconductor 211, and the type-B semiconductor 212.

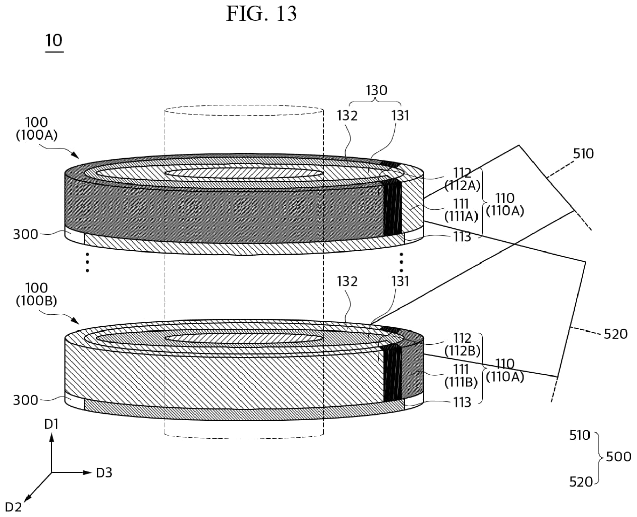

FIG. 13 is a perspective view illustrating at least a portion of the radioactive cell 10 according to an example embodiment of the present disclosure. The following description may refer to the description of FIG. 1 to FIG. 12 as long as it is not contradictory.

In an example, the radioactive cell 10 may include: the plurality of radioactive unit cells 100 including the electrode layer 110, the radioactive source 120, and the energy conversion layer 130; the insulating layer 300 that is provided in at least a gap among gaps that exist between any adjacent radioactive unit cells 100A and 100B among the plurality of radioactive unit cells 100 and provided at positions corresponding to the electrode layers 110A and 110B of the adjacent radioactive unit cells 100A and 100B, respectively; a connecting part 500 including a first connecting part 510 electrically connecting first electrodes 111A and 111B of the adjacent radioactive unit cells 100A and 100B and a second connecting part 520 electrically connecting each of the second electrode 112A and the second electrode 112B of the adjacent radioactive unit cells 100A and 100B.

In an example, the connecting part 500 may include a junction electrically connected with the electrode 110 of each of the plurality of radioactive unit cells 100 and a collective junction where the junctions are gathered. That is, the first connecting part 510 may include a first junction electrically connected with the first electrode 111 of each of the plurality of radioactive unit cells 100 and a first collective junction where the first junctions are gathered. That is, the second connecting part 520 may include a second junction electrically connected with the second electrode 112 of each of the plurality of radioactive unit cells 100 and a second collective junction where the second junctions are gathered. In an example, the first collective junction and the second collective junction may be electrically connected with a load, whereby the radioactive cell 10 may supply power to the load.

In an example, the energy conversion layer 130 of at least some of the plurality of radioactive unit cells 100 may extend to the region where the insulating layer 300 is provided. In an example, the adjacent radioactive unit cells 100A and 100B may be electrically connected through the connecting part 500 instead of the connector 200 described above, and the energy conversion layers 130 included in the adjacent radioactive unit cells 100A and 100B may be connected to each other. In an example, the energy conversion layers 130 included in the adjacent radioactive unit cells 100A and 100B may be integrally formed.

According to an example embodiment of the present disclosure, the electric power device may include the radioactive cell 10 and a shielding member containing the radioactive cell 10. The shielding member may include a material capable of shielding or reflecting radiation. For example, the shielding member may include one or more of metallic materials such as copper, silver and aluminum, and polymeric materials such as polyolefin, polyester and poly(meta)acrylate. The polyolefin may include, but is not limited to, one or more of polyethylene, polypropylene and ethylene-propylene copolymer. Polyester may include, but is not limited to, polyethylene terephthalate. Poly(meta)acrylate may include, but is not limited to, ethylene-(meta)acrylate copolymer. The shielding member may contain at least one of lead (Pb) and concrete, for example, if the isotope emitting gamma rays is included in the radioactive source 120. The shielding member may minimize electromagnetic interference, parasitic circuit occurrence, or power loss caused by the operation of the plurality of radioactive unit cells 100 and the connector 200.

Although various example embodiments of the present disclosure were described in detail above, it would be apparent to those skilled in the art that the scope of the present disclosure is not limited thereto and the present disclosure may be changed and modified in various ways without departing from the spirit of the present disclosure described in claims. Further, some components may be removed in the example embodiments described above and the example embodiments may be combined with each other.

### [Description of Reference Numerals]

10..Radioactive cell.
100...Radioactive unit cell
110...Electrode layer
120...Radioactive source
130...Energy conversion layer
140...Dielectric layer
200...Connector
210...Semiconductor layer
300...Insulating layer
500...Connecting part

### [Representative Drawing]

FIG.1

## Claims

1. A radioactive cell comprising:
a plurality of radioactive unit cells that includes an electrode layer including a first electrode, a second electrode, and an electrode insulation layer provided between the first electrode and the second electrode, a radioactive source, and an energy conversion layer surrounding at least a portion of the radioactive source and provided between the electrode layer and the radioactive source, and is stacked in a stacking direction that is one direction; and
a connector provided in at least a gap among gaps that exist between any adjacent radioactive unit cells among the plurality of radioactive unit cells, and electrically connecting each electrode layer of the adjacent radioactive unit cells.

2. The radioactive cell of claim 1, wherein the electrode layer surrounds at least a portion of the energy conversion layer.

3. The radioactive cell of claim 2, wherein the energy conversion layer includes a type-I semiconductor and a type-II semiconductor,
the first electrode surrounds at least a portion of the type-I semiconductor, and
the second electrode surrounds at least a portion of the type-II semiconductor.

4. The radioactive cell of claim 3, wherein the electrode insulation layer surrounds at least a portion of a boundary between the type-I semiconductor and the type-II semiconductor.

5. The radioactive cell of claim 3, wherein the type-I semiconductor surrounds at least a portion of the radioactive source, and
the type-II semiconductor surrounds a portion of the type-I semiconductor.

6. The radioactive cell of claim 2, wherein the energy conversion layer includes a first energy conversion layer and a second energy conversion layer each including a type-I semiconductor and a type-II semiconductor,
the first energy conversion layer surrounds at least a portion of the radioactive source, and
the second energy conversion layer surrounds at least a portion of the fist energy conversion layer.

7. The radioactive cell of claim 6, wherein the type-I semiconductor of the second energy conversion layer surrounds at least a portion of the type-II semiconductor of the first energy conversion layer, and the type-II semiconductor of the second energy conversion layer surrounds at least a portion of the type-I semiconductor of the first energy conversion layer.

8. The radioactive cell of claim 1, wherein at least some of the plurality of radioactive unit cells further include a dielectric layer that surrounds at least a portion of the radioactive source.

9. The radioactive cell of claim 1, wherein the connector includes a plurality of connectors, and
some of the connectors electrically connect the first electrode of one of the adjacent radioactive unit cells and the second electrode of the other one, and the others of the connectors electrically connect the second electrode of one of the adjacent radioactive unit cells and the first electrode of the other one.

10. The radioactive cell of claim 1, wherein the connector includes a plurality of connectors, and
some of the connectors electrically connect the first electrode of one of the adjacent radioactive unit cells and the first electrode of the other one, and the others of the connectors electrically connect the second electrode of one of the adjacent radioactive unit cells and the second electrode of the other one.

11. The radioactive cell of claim 1, further comprising:
an insulating layer that is provided in at least a gap among the gaps that exist between the adjacent radioactive unit cells,
wherein the radioactive source is provided through the insulating layer in the stacking direction.

12. The radioactive cell of claim 11, wherein the connector is provided through the insulating layer in the stacking direction.

13. The radioactive cell of claim 11, wherein the insulating layer further includes a dielectric layer surrounding at least a portion of the radioactive source provided in the insulating layer.

14. The radioactive cell of claim 11, wherein the insulating layer further includes a semiconductor layer that surrounds at least a portion of the radioactive source provided in the insulating layer.

15. The radioactive cell of claim 14, wherein the semiconductor layer is exposed from the insulating layer and is in contact with the energy conversion layer of each of the adjacent radioactive unit cells in the stacking direction.

16. The radioactive cell of claim 14, wherein the semiconductor layer includes a type-A semiconductor and a type-B semiconductor,
the type-A semiconductor surrounds at least a portion of the radioactive source provided in the insulating layer, and
the type-B semiconductor surrounds at least a portion of the type-A semiconductor.

17. The radioactive cell of claim 14, wherein the semiconductor layer includes a first semiconductor layer and a second semiconductor layer each including a type-A semiconductor and a type-B semiconductor,
the first semiconductor layer surrounds at least a portion of the radioactive source provided in the insulating layer, and
the second semiconductor layer surrounds at least a portion of the first semiconductor layer.

18. The radioactive cell of claim 17, wherein the type-A semiconductor of the second semiconductor layer surrounds at least a portion of the type-B semiconductor of the first semiconductor layer, and the type-B semiconductor of the second semiconductor layer surrounds at least a portion of the type-A semiconductor of the first semiconductor layer.

19. The radioactive cell of claim 18, wherein the energy conversion layer includes a first energy conversion layer and a second energy conversion layer each including a type-I semiconductor and a type-II semiconductor, the first energy conversion layer surrounds at least a portion of the radioactive source, and the second energy conversion layer surrounds at least a portion of the first energy conversion layer; and
the first semiconductor layer is in contact with the first energy conversion layer in at least a partial region in the stacking direction, and the second semiconductor layer is in contact with the second energy conversion layer in at least a partial region in the stacking direction.

20. The radioactive cell of claim 19, wherein the type-I semiconductor of the second energy conversion layer surrounds at least a portion of the type-II semiconductor of the first energy conversion layer, and the type-II semiconductor of the second energy conversion layer surrounds at least a portion of the type-I semiconductor of the first energy conversion layer; and
the type-A semiconductor and the type-B semiconductor of the first semiconductor layer are in contact with at least a portion of the type-I semiconductor and the type-II semiconductor of the first energy conversion layer, respectively, and the type-A semiconductor and the type-B semiconductor of the second semiconductor layer are in contact with at least a portion of the type-I semiconductor and the type-II semiconductor of the second energy conversion layer, respectively.

21. The radioactive cell of claim 20, wherein the type-A semiconductor of the first semiconductor layer and the type-I semiconductor of the first energy conversion layer have types different from each other, and the type-B semiconductor of the first semiconductor layer and the type-II semiconductor of the first energy conversion layer have types different from each other; and
the type-A semiconductor of the second semiconductor layer and the type-I semiconductor of the second energy conversion layer have types different from each other, and the type-B semiconductor of the second semiconductor layer and the type-II semiconductor of the second energy conversion layer have types different from each other.

22. A radioactive cell comprising:
a plurality of radioactive unit cells that includes an electrode layer including a first electrode, a second electrode, and an electrode insulation layer provided between the first electrode and the second electrode, a radioactive source, and an energy conversion layer surrounding at least a portion of the radioactive source and provided between the electrode layer and the radioactive source, and is stacked in a stacking direction that is one direction;
an insulating layer that is provided in at least a gap among gaps that exist between any adjacent radioactive unit cells among the plurality of radioactive unit cells, and provided at a position corresponding to the electrode layer of each of the adjacent radioactive unit cells; and
a connecting part that includes a first connecting part electrically connecting each of the first electrodes of the adjacent radioactive unit cells and a second connecting part electrically connecting each of the second electrodes of the adjacent radioactive unit cells.
